# DEMANDE DE BREVET EUROPEEN

(11) **EP 2 597 067 A1**
(43) Date de publication de la demande: **29.05.2013**
(21) Numéro de dépôt: 11190264.9
(22) Date de dépôt: 23.11.2011
(51) Int. Cl.: B81C 1/00

(54) **Procédé de fabrication d'un dispositif d'encapsulage**

(71) Demandeur: Micro Crystal AG, 2540 Grenchen (CH)
(72) Inventeur: Deillon, Léa, 1007 Lausanne (CH); Dalla Piazza, Silvio, 2610 St-Imier (CH); Hessler, Thierry, 2024 St-Aubin (CH)
(74) Mandataire: Couillard, Yann Luc Raymond

(57) **Abrégé**

L'invention se rapporte à un élément (2, 4, 44, 64) agencé pour coopérer avec une autre pièce (4, 2) afin de former un dispositif d'encapsulage (3) d'un composant (5) comportant l'élément (2, 4) au moins partiellement revêtu d'une métallisation (11, 9, 49, 69). Selon l'invention, ladite métallisation comporte au moins une couche (15) de métal protégé par un intermétallique (19, 59, 79) lequel est recouvert par une partie (12', 52', 72') non diffusée d'un matériau dont le point de fusion est inférieur à 250 °C.

L'invention concerne également un procédé (21) de fabrication d'un dispositif d'encapsulage (3).

## Description

### Domaine de l'invention

L'invention se rapporte à un procédé de fabrication d'un dispositif d'encapsulage pour un système électro-micromécanique (également connu sous l'abréviation MEMS provenant des termes anglais « Micro Electro Mechanical System ») et, notamment, pour un MEMS du type résonateur à quartz.

### Arrière plan de l'invention

Les composants électroniques ayant un MEMS sont formés généralement par un boîtier hermétiquement fermé dans lequel est monté le MEMS. Le MEMS peut être par exemple un résonateur piézoélectrique, tel qu'un résonateur à quartz destiné à être relié à un circuit oscillateur. La plupart des résonateurs à quartz de petites dimensions, qui sont utilisés par exemple dans les montres électroniques ou électromécaniques, sont des résonateurs du type diapason.

De tels résonateurs à quartz sont habituellement enfermés sous vide dans des boîtiers, dans le cas de la génération de signaux basse fréquence fournis par le circuit oscillateur, ou sous atmosphère de gaz inerte. De plus, une partie du couvercle peut être transparente à une longueur d'onde déterminée d'un faisceau de lumière afin de permettre le réglage optique du résonateur à quartz.

Généralement, de tels résonateurs sont montés dans des boîtiers par exemple en céramique qui sont relativement plats. Ces boîtiers comprennent une partie principale creuse de forme parallélépipédique à l'intérieur de laquelle est monté le résonateur, et un couvercle rectangulaire fixé sur la partie principale.

Afin d'assurer l'étanchéité entre le couvercle et la partie principale, actuellement, on utilise un joint en alliage métallique eutectique à base d'or et d'étain qui est rapporté entre les deux parties puis l'ensemble est chauffé afin de sceller définitivement le boîtier sous atmosphère contrôlée.

Ces alliages à base d'or et d'étain présentent les inconvénients d'utiliser des matériaux intrinsèquement chers et de posséder un point de fusion relativement bas, c'est-à-dire autour de 278 °C. Cette dernière caractéristique limite les procédés possibles lors de ou après la connexion du boîtier sur son support d'utilisation comme un circuit imprimé, par exemple. On comprend en effet qu'aucun traitement thermique supérieur à 280 °C réalisé ultérieurement à la connexion n'est possible sous risque de descellement du boîtier qui, même partiel, ferait perdre l'herméticité du dispositif et donc les performances du résonateur.

### Résumé de l'invention

Le but de la présente invention est de pallier tout ou partie les inconvénients cités précédemment en proposant un nouveau type de dispositif d'encapsulage hermétique et son procédé de fabrication.

De plus, l'invention se rapporte à un élément agencé pour coopérer avec une autre pièce afin de former un dispositif d'encapsulage d'un composant comportant l'élément au moins partiellement revêtu d'une métallisation caractérisé en ce que ladite métallisation comporte au moins une couche de métal protégé par un intermétallique lequel est recouvert par une partie non diffusée d'un matériau dont le point de fusion est inférieur à 250 °C.

Avantageusement selon l'invention, ladite au moins une couche de métal est protégée par le (ou les) intermétallique(s) qui forme une barrière de protection. De plus, il reste du matériau dont le point de fusion est inférieur à 250°C pour la future formation des moyens d'étanchéité.

Conformément à d'autres caractéristiques avantageuses de l'invention :
- l'élément est un couvercle destiné à fermer ledit dispositif d'encapsulage ;
- l'élément est une partie principale destinée à former une cavité (10) du dispositif d'encapsulage ;
- l'élément est formé en céramique ou en métal ;
- ladite au moins une couche de métal comporte du nickel et/ou du cuivre et/ou de l'or ;
- ladite au moins une couche de métal est formé par le corps de l'élément ;
- ladite au moins une couche de métal comporte en outre une couche d'accrochage contre ledit corps de l'élément ;
- la couche d'accrochage comporte du molybdène et/ou du tungstène et/ou du titane et/ou du chrome ;
- l'intermétallique comporte de l'or ;
- ledit matériau dont le point de fusion est inférieur à 250 °C est de l'indium ou de l'étain.

De plus, l'invention se rapporte à un procédé de fabrication d'un élément agencé pour coopérer avec une autre pièce afin de former un de dispositif d'encapsulage d'un composant comportant les étapes suivantes :
a) former l'élément ;
b) déposer une métallisation comportant au moins une couche de
   métal protégé par un revêtement ;
   caractérisé en ce qu'il comporte en outre les étapes suivantes :
c) déposer une couche d'un matériau dont le point de fusion est inférieur à 250 °C sur le revêtement ;
d) diffuser partiellement le matériau dont le point de fusion est inférieur à 250°C dans le revêtement afin d'entièrement transformer le revêtement en un intermétallique et laisser une partie non diffusée du matériau dont le point de fusion est inférieur à 250 °C.

Avantageusement selon l'invention, le matériau dont le point de fusion est inférieur à 250 °C qui est déposé est un matériau pur et non un alliage eutectique à base d'or pour la future formation des moyens d'étanchéité.

Conformément à d'autres caractéristiques avantageuses de l'invention :
- l'élément est formé en céramique ou en métal ;
- ladite au moins une couche de métal comporte du nickel et/ou du cuivre et/ou de l'or ;
- ladite au moins une couche de métal est formé par le corps de l'élément ;
- le procédé comporte, entre l'étape a) et l'étape b), une étape consistant à déposer une couche d'accrochage pour ladite au moins une couche de métal ;
- la couche d'accrochage comporte du molybdène et/ou du tungstène et/ou du titane et/ou du chrome ;
- le revêtement comporte de l'or.

En outre, l'invention se rapporte à un dispositif d'encapsulage agencé pour recevoir un composant comportant un boîtier comprenant une partie principale formant une cavité qui est fermée hermétiquement par un couvercle à l'aide de moyens d'étanchéité caractérisé en ce que les moyens d'étanchéité comportent un intermétallique formé par au moins un métal avec un matériau dont le point de fusion est inférieur à 250 °C afin de permettre son interdiffusion à l'état liquide avec ledit au moins un métal.

Conformément à d'autres caractéristiques avantageuses de l'invention :
- les moyens d'étanchéité comportent un deuxième intermétallique adjacent audit premier intermétallique formé par au moins un deuxième métal avec le matériau dont le point de fusion est inférieur à 250 °C ;
- ledit au moins un deuxième métal comporte de l'or ;
- les moyens d'étanchéité comportent un troisième intermétallique de nature sensiblement identique au premier intermétallique, le premier et le troisième intermétallique étant situé de chaque côté du deuxième intermétallique ;
- les moyens d'étanchéité comportent au moins une couche d'accrochage contre le boîtier ;
- les moyens d'étanchéité comportent une couche dudit au moins un métal entre le couvercle et ledit intermétallique et entre la partie principale et ledit intermétallique ;
- les moyens d'étanchéité comportent une couche dudit au moins un métal entre la partie principale et ledit intermétallique et dans le couvercle ;
- ledit matériau dont le point de fusion est inférieur à 250 °C est de l'indium ou de l'étain ;
- ledit au moins un métal comporte du nickel et/ou du cuivre et/ou de l'or ;
- le boîtier est formé en céramique et/ou en métal ;
- la cavité est sous vide ou sous atmosphère contrôlée.

Enfin, l'invention se rapporte à un procédé de fabrication d'un dispositif d'encapsulage d'un composant caractérisé en ce qu'il comporte les étapes suivantes :
e) former ledit composant ;
f) fabriquer une partie principale comportant une première métallisation et formant une cavité, et un couvercle comportant une deuxième métallisation, la partie principale ou le couvercle étant réalisé conformément au procédé selon l'une des variations précédentes ;
g) monter le composant dans la cavité ;
h) assembler la partie non diffusée du matériau dont le point de fusion est inférieur à 250°C lors de l'étape d) de la partie principale ou du couvercle contre respectivement la métallisation du couvercle ou de la partie principale ;
i) diffuser totalement la partie non diffusée du matériau dont le point de fusion est inférieur à 250 °C dans ladite métallisation adjacente afin d'entièrement transformer le matériau dont le point de fusion est inférieur à 250 °C en un deuxième intermétallique apte à fermer hermétiquement ledit composant dans le dispositif d'encapsulage.

A partir des boîtiers actuels dont les métallisations comportent déjà du nickel, on comprend donc que seul le matériau à bas point de fusion est nécessaire d'être rapporté pour effectuer l'herméticité du boîtier. De plus, la base en nickel est sensiblement moins chère que celle en or et permet en outre d'obtenir au moins un intermétallique dont le point de fusion est situé à une température plus élevée que les moyens d'étanchéité actuels et donc compatible avec les températures utilisées dans les procédés standard de montage du dispositif, sans risque de perte d'herméticité.

En outre, par rapport aux moyens d'étanchéité actuels, il est apparu que le (ou les) deuxième(s) intermétallique(s) formé(s) à partir du nickel a des cinétiques de croissance plus lentes ce qui permet avantageusement de mieux contrôler leur formation. Enfin, le (ou les) deuxième(s) intermétallique(s) est formé uniquement à partir de ladite au moins une couche de nickel de la partie principale grâce au(x) premier(s) intermétallique(s) qui bloque toute autre diffusion.

Conformément à d'autres caractéristiques avantageuses de l'invention :
- le procédé comporte, entre l'étape f) et l'étape g), l'étape consistant à déposer une couche de protection afin de protéger ladite métallisation formée non recouverte par la partie non diffusée ;
- la partie principale et le couvercle sont formés en céramique et/ou en métal ;
- l'étape i) est réalisée sous vide ou sous atmosphère contrôlée ;
- ledit composant est un résonateur diapason à quartz ;
- le matériau dont le point de fusion est inférieur à 250°C est de l'indium ou de l'étain.

### Description sommaire des dessins

D'autres particularités et avantages ressortiront clairement de la description qui en est faite ci-après, à titre indicatif et nullement limitatif, en référence aux dessins annexés, dans lesquels :
- la figure 1 est une vue de dessus du composant électronique selon l'invention ;
- la figure 2 est une vue selon la coupe A-A de la figure 1 du composant électronique selon l'invention ;
- les figures 3 et 4 sont des vues agrandies localisées sur le couvercle avant et après la première diffusion selon l'invention ;
- la figures 5 est une vue agrandie localisée sur la partie principale avant la deuxième diffusion selon l'invention ;
- la figures 6 est une vue agrandie localisée sur l'interface entre la partie principale et le couvercle après la deuxième diffusion selon l'invention ;
- la figure 7 est un schéma fonctionnel du procédé de fabrication selon l'invention
- la figure 8 est une vue en coupe d'un exemple de moyens d'étanchéité obtenus selon l'invention ;
- la figure 9 est une vue partielle et agrandie de la figure 8 ;
- les figures 10 et 11 sont des vues agrandies localisées sur une première variante de couvercle avant et après la première diffusion selon l'invention ;
- les figures 12 et 13 sont des vues agrandies localisées sur une deuxième variante de couvercle avant et après la première diffusion selon l'invention.

### Description détaillée des modes de réalisation préférés

Dans la description suivante, toutes les parties du composant qui sont bien connues d'un homme du métier dans ce domaine technique, ne seront pas expliquées en détail.

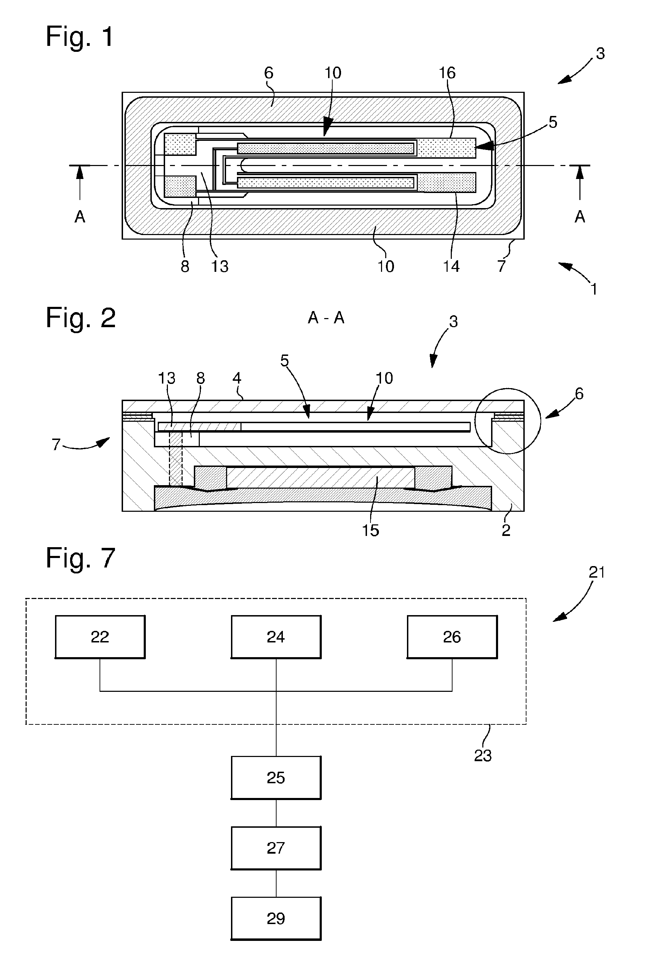

Le composant électronique 1 est représenté de manière simplifiée aux figures 1 et 2. Il comporte principalement un dispositif d'encapsulage 3 destiné à recevoir un MEMS 5 de manière hermétique. Le dispositif d'encapsulage 3 comprend un boîtier 7 formé par une partie principale creuse 2 et un couvercle 4 destiné à fermer la partie creuse 2 à l'aide de moyens d'étanchéité 6.

Dans l'exemple illustré aux figures 1 et 2, le MEMS 5 représenté est un résonateur diapason à quartz, cependant d'autres types de MEMS 5 nécessitant un encapsulage sous vide ou sous atmosphère contrôlée sont également applicables.

La partie creuse 2 est généralement de forme parallélépipédique et comporte une portée 8 dans la cavité 10 intérieure destinée à fixer le MEMS 5 en porte-à-faux. Les extrémités libres des parois entourant la cavité 10 sont destinées à recevoir le couvercle 4 de forme sensiblement rectangulaire à l'aide des moyens d'étanchéité 6 afin d'enfermer de manière hermétique le MEMS 5 dans le dispositif d'encapsulage 3.

A titre d'exemple, le boîtier 7, c'est-à-dire la partie creuse 2 et le couvercle 4, peut être de 5 mm de long, 3,2 mm de large et 1,08 mm de haut. De plus, le boîtier 7 est de préférence réalisé en céramique selon une technique habituelle.

Les moyens d'étanchéité 6 sont formés par une succession de couches destinées à adhérer à la céramique et à former la couche autorisant l'herméticité. Avantageusement selon l'invention, les moyens d'étanchéité 6 comportent un alliage à base de nickel associé à un matériau dont le point de fusion est bas, c'est-à-dire très inférieur à celui du nickel comme par exemple de l'ordre de 250 °C maximum. De manière préférée, le matériau utilisé peut être de l'indium ou de l'étain.

Ces alliages In-Ni ou Ni-Sn, qui peuvent comporter plusieurs intermétalliques, sont obtenus par une soudure faisant intervenir une interdiffusion solide-liquide, c'est-à-dire que la différence de point de fusion entre l'indium ou l'étain par rapport à celui de nickel permet de fondre un de ces premiers matériaux et de le faire diffuser dans la couche de nickel solide afin de former des intermétalliques.

Ces soudures peuvent ainsi être réalisées à « basse » température, c'est-à-dire en dessous de 250 °C tout en acceptant des traitements thermiques postérieurs à des températures bien supérieures induites par les points de fusion des intermétalliques obtenus, c'est-à-dire compris entre 400 °C et 800 °C.

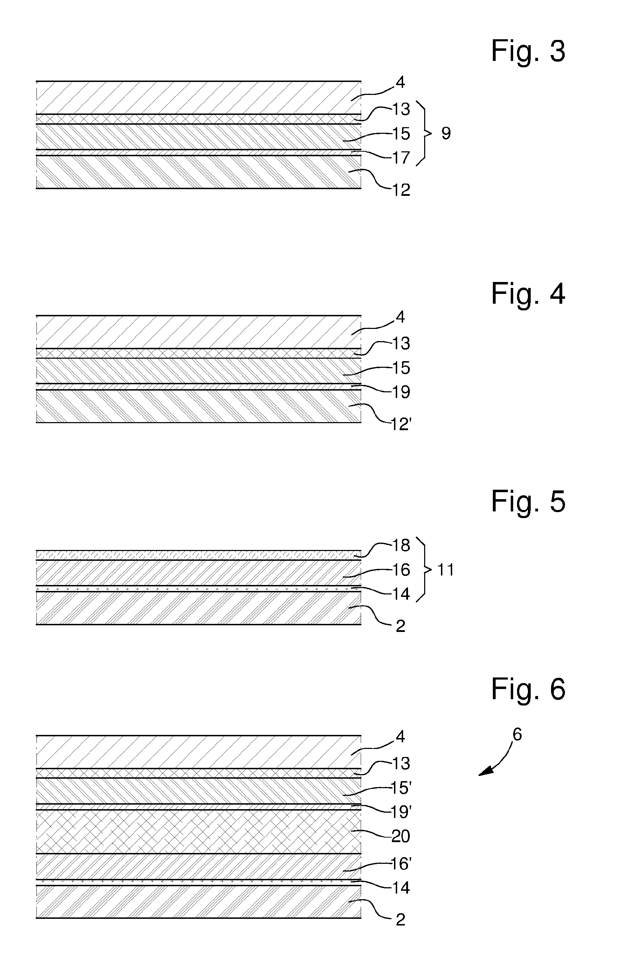

Avantageusement selon l'invention, les boîtiers céramiques 7 commercialisés actuellement comportent des métallisations 9, 11 qui comprennent déjà au moins une couche de nickel comme visible aux figures 3 et 5.

Typiquement comme visible à la figure 3, la métallisation 9 du couvercle 4 comporte plusieurs couches. Une première couche optionnelle d'accrochage 13 formée avec, par exemple, du molybdène ou du tungstène et au moins une couche de métal 15 comme du nickel. La métallisation 9 peut également comporte un revêtement 17 de protection contre l'oxydation par exemple en or. Les couches d'accrochage 13 et de métal 15 ont des épaisseurs respectivement de 10 µm et de 5 µm tandis que le revêtement 17 de protection est d'environ 0,75 µm.

De manière similaire comme visible à la figure 5, la métallisation 11 de la partie principale 2 comporte également plusieurs couches. Une première couche optionnelle d'adhérence 14 formée avec, par exemple, du molybdène ou du tungstène et au moins une couche de métal 16 comme du nickel. La métallisation 11 peut également comporter une couche 18 de protection contre l'oxydation par exemple en or. Les couches d'adhérence 14 et de métal 16 ont des épaisseurs respectivement de 10 µm et de 5 µm tandis que celle 18 de protection est d'environ 0,75 µm.

Dès lors, on comprend que, pour former les moyens d'étanchéité 6 en un intermétallique indium-nickel ou nickel-étain, une seule couche 12 d'indium pur ou d'étain pur est nécessaire pour réaliser la soudure par interdiffusion solide-liquide selon l'invention.

Par conséquent, le MEMS 5 peut, à l'aide des moyens d'étanchéité 6, être enfermé sous vide ou sous atmosphère contrôlée dans la cavité 10 du dispositif d'encapsulage 3 avec des matériaux moins coûteux et en obtenant au moins un intermétallique dont le point de fusion est situé à une température plus élevée que les moyens d'étanchéité actuels.

Dans l'exemple illustré aux figures 1 et 2, le MEMS 5 est un diapason en quartz classique constitué de deux branches 14, 16 parallèles pour vibrer en mode de flexion dont la base commune 13 est fixée sur la portée 8. Les couches de métallisation du MEMS 5 nécessaires à l'actionnement piézoélectrique ainsi que les plages de connexion à un circuit intégré 15 ayant, par exemple, un étage oscillateur ne sont pas présentés en détail car ces éléments ne sont pas déterminants pour l'application de l'invention.

Le procédé 21 de fabrication du dispositif d'encapsulage 3 va maintenant être expliqué en référence aux figures 3 à 7. Le procédé 21 comporte une première étape 23 destinée à fabriquer, de manière indépendante, lors de phases 22, 24 et 26, respectivement le MEMS 5, le couvercle 4 et la partie creuse 2.

Ainsi, si le MEMS 5 est un résonateur diapason en quartz, la phase 22 peut consister à graver dans un monocristal de quartz une plaquette, puis graver le corps du diapason dans l'épaisseur de cette plaquette pour enfin instrumenter le diapason, c'est-à-dire déposer les couches électriquement conductrices nécessaires à son fonctionnement.

Le couvercle 4 est préférentiellement formé l'aide d'une céramique lors de la phase 24. Pour ce faire, de manière habituelle, une ou plusieurs feuilles de céramique sont ouvragées, empilées et fixées les unes sur les autres. Ensuite, le couvercle 4 est partiellement métallisé pour permettre la future coopération avec la partie principale 2. Selon l'invention, après la formation du couvercle 4, on dépose donc au moins une couche 15 de métal protégé par un revêtement 17.Le couvercle 4 comporte ainsi plusieurs couches de métaux. Une première couche optionnelle d'accrochage 13 formée avec, par exemple, du molybdène et/ou du tungstène et/ou du titane et/ou du chrome et au moins une couche de métal 15 comme du nickel.

Les couches d'accrochage 13 et de métal 15 peuvent avoir des épaisseurs de respectivement 10 µm et de 5 µm tandis que le revêtement 17 de protection est d'environ 0,75 µm.

La partie principale 2 est préférentiellement formée l'aide d'une céramique lors de la phase 26. Pour ce faire, de manière habituelle, plusieurs feuilles de céramique sont ouvragées, empilées et fixées les unes sur les autres. Ensuite, la partie principale 2 est partiellement métallisée pour permettre la future coopération avec le couvercle 4.

Selon l'invention, après la formation de la partie principale 2, on dépose donc au moins une couche de métal 16 comme du nickel éventuellement protégé par un revêtement 18 qui peut par exemple être en or. De plus, préalablement au dépôt de couche 16 par exemple en nickel, une étape intermédiaire destinée à déposer une couche d'adhérence 14 pour la couche 16 peut être réalisée.

Comme expliqué ci-dessus, la partie principale 2 comporte ainsi plusieurs couches de métaux. Une première couche optionnelle d'adhérence 14 formée avec, par exemple, du molybdène et/ou du tungstène et/ou du titane et/ou du chrome et au moins une couche de métal 16. La couche 16 peut comporter un revêtement 18 de protection contre l'oxydation par exemple en or comme illustré à la figure 5.

Les couches d'adhérence 14 et de nickel 16 peuvent avoir des épaisseurs de respectivement 10 µm et de 5 µm tandis que le revêtement 18 de protection optionnel est d'environ 0,75 µm. Ces dépôts peuvent être réalisés, par exemple, par sérigraphie, galvanoplastie ou dépôt physique en phase vapeur.

Avantageusement selon l'invention, la phase 24 ou la phase 26 du procédé 21 se poursuit avec une étape destinée à déposer une couche 12 d'un matériau dont le point de fusion est inférieur à 250 °C sur le revêtement 17, 18 par exemple formé en or du couvercle 4 ou de la pièce principale 2. Comme expliqué ci-dessus, le matériau dont le point de fusion est inférieur à 250 °C peut être de l'indium ou de l'étain. Une représentation dans laquelle la couche 12 est déposée sur le couvercle 4 est visible à la figure 3.

L'épaisseur de la couche 12 est importante car, dans un premier temps, elle est utilisée pour former un premier intermétallique avec une des couches de protection 17, 18 et, dans un deuxième temps, elle est utilisée pour former un deuxième intermétallique avec au moins une des couches de la métallisation 11, 9 de la partie principale 2 ou du couvercle 4 comme expliqué ci-dessous.

Ainsi, la phase 24 ou 26 se termine par une étape destinée à diffuser partiellement le matériau dont le point de fusion est inférieur à 250°C dans le revêtement 17, 18 afin d'entièrement transformer le revêtement 17, 18 en un intermétallique apte à former une couche 19 de protection de ladite au moins une couche 15 de métal. Une représentation dans laquelle la couche 19 est formée sur le couvercle 4 est visible à la figure 4.

On comprend donc qu'une partie de la couche 12 est utilisée et qu'à la fin de la phase 24 ou 26, la couche 12 devient la couche 12' moins épaisse mais toujours de même nature. Avantageusement selon l'invention, l'étape de diffusion peut être réalisée à température ambiante, il est toutefois possible de l'accélérer en chauffant l'ensemble.

L'épaisseur de ladite au moins une couche 15, 16 de métal utilisée pour la diffusion finale est également importante car elle est utilisée pour « consommer » entièrement la couche 12' en formant un deuxième intermétallique destiné à fermer hermétiquement le boîtier 7. La nature de l'autre au moins une couche 16, 15 de métal présente lors de la première diffusion a moins d'importance en ce qu'elle va peu ou pas interagir.

A la fin de l'étape 24 ou 26, on comprend que ladite au moins une couche 15, 16 comporte un revêtement 19 de protection contre l'oxydation par exemple en alliage or-indium ou or-étain et la couche 12' qui est le reste non diffusé de la couche 12 en indium ou en étain comme illustré à la figure 4. La couche 12 peut comporter une épaisseur comprise entre 15 et 60 µm.

Après diffusion, les couches 13, 14 et 15, 16 restent inchangées. Par contre, on obtient une couche 19 de protection de l'ordre de 5 µm et une couche 12' comprise entre 13,5 et 58,5 µm. Ces dépôts peuvent être réalisés, par exemple, par sérigraphie, galvanoplastie ou dépôt physique en phase vapeur.

Dans une deuxième étape 25, le MEMS 5 est monté dans la cavité 10 de la partie creuse 2 puis, lors de la troisième étape 27, le boîtier 7 est assemblé en mettant en vis-à-vis les couches métalliques afin de les mettre en contact. Enfin, le procédé 21 comporte une dernière étape 29 consistant à souder les couches métalliques pour former les moyens d'étanchéité 6 et ainsi définitivement sceller le dispositif d'encapsulage 3. Comme expliqué ci-avant, suivant le MEMS 5 à encapsuler, l'étape 29 et, éventuellement, l'étape 27 est (sont) réalisée(s) sous vide ou sous atmosphère contrôlée.

L'étape 29 est destinée à diffuser totalement le reste 12' du matériau dont le point de fusion est inférieur à 250 °C dans ladite au moins une couche 15, 16 lui faisant face afin d'entièrement transformer le matériau dont le point de fusion est inférieur à 250 °C en un deuxième intermétallique 20 apte à fermer hermétiquement ledit composant dans le dispositif d'encapsulage 3 même pour des températures comprises entre 400 et 800 °C. L'étape 29 peut consister à presser le couvercle 4 contre le la partie creuse 2 tout en liquéfiant par chauffage la couche 12'.

On comprend donc que la couche 12' est totalement « consommée » par les couches 16 et/ou 15 en formant une couche 20 d'un deuxième intermétallique par exemple à base d'indium-nickel ou de nickel-étain. Toutefois, il subsiste des couches 16' et/ou 15'qui sont le reste non diffusé de la couche 16 et/ou 15 comme illustré à la figure 6.

Par conséquent, après diffusion, il reste les couches 15' et 16' de métal comme par exemple du nickel et, éventuellement, les couches 13 et 14 qui restent inchangées. Dans le cas où une couche 18 de protection est utilisée, elle migrerait en épaississant la couche 19 qui deviendrait 19' comme illustré à la figure 6.

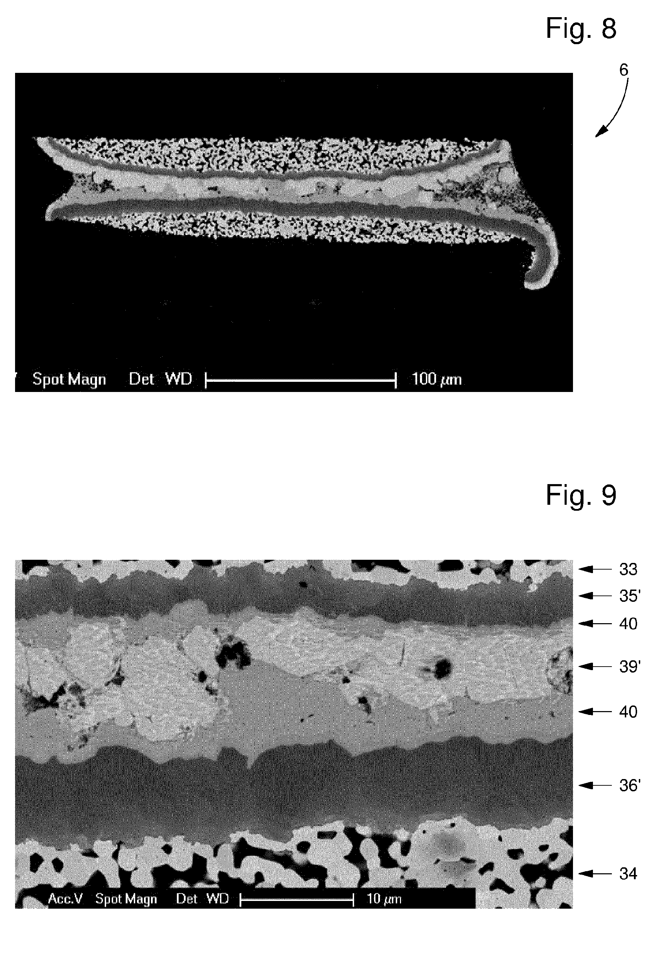

Un autre exemple de moyens d'étanchéité 6 obtenu selon l'invention est présenté aux figures 8 et 9. Dans cette variante, le matériau dont le point de fusion est inférieur à 250 °C est de l'indium, les couches de protection de l'or et lesdites couches de métaux du nickel-cobalt. Comme visible aux figures 8 et 9, on obtient du haut vers le bas, une couche 33 d'accrochage (W), une première couche 35' de métal (NiCo), une première couche 40 d'intermétallique (InNiAu), une couche d'intermétallique 39' (Auln₂), une deuxième couche 40 d'intermétallique (InNiAu), une couche 36' (NiCo) et une couche 33 d'accrochage (W). Avantageusement selon l'invention, le couvercle 4 peut être indifféremment au-dessus de la couche 33 ou en dessous de la couche 34.

On comprend également au vu de l'exemple de la figure 9 par rapport à celui de la figure 6 que les deux au moins une couche de métal peuvent interagir l'une et l'autre pour former deux intermétalliques 40 entourant l'intermétallique 39' formé lors de la phase 24 ou 26 sans sortir du cadre de l'invention.

Avantageusement selon l'invention, par rapport aux moyens d'étanchéité actuels, il est apparu que les intermétalliques formés à partir du nickel en plus de leur coût inférieur ont des cinétiques de croissance plus lentes ce qui permet avantageusement de mieux contrôler leur formation.

A titre optionnel, si le MEMS 5 est un résonateur diapason en quartz, il peut être nécessaire de l'ajuster ou de le régler. Ce réglage peut être effectué après l'étape 25 ou après l'étape 29. Dans ce dernier cas, c'est-à-dire quand le couvercle 4 a déjà fermé hermétiquement la partie creuse 2 du boîtier 7 sous vide, le couvercle 4 devra comprendre au moins une portion transparente à une longueur d'onde déterminée d'un faisceau de lumière, tel qu'un faisceau laser, utilisé pour réaliser ledit réglage.

A l'aide du présent procédé 21, le composant électronique 1 formé est ainsi configuré comme un composant de type SMD (abréviation des termes anglaise « Surface Mounting Device »). A ce titre, il peut être monté et connecté par brasage par exemple sur une plaque de circuit imprimé.

Bien entendu, la présente invention ne se limite pas à l'exemple illustré mais est susceptible de diverses variantes et modifications qui apparaîtront à l'homme de l'art. En particulier, le composant électronique 1 peut ne comprendre que l'élément résonateur 5 ou, à titre alternatif, le procédé 21 pourrait être adapté pour réaliser un processus du type « wafer level packaging » c'est-à-dire un encapsulage en série à partir de deux plaquettes l'une contre l'autre qui sont postérieurement découpées pour former le composant électronique 1.

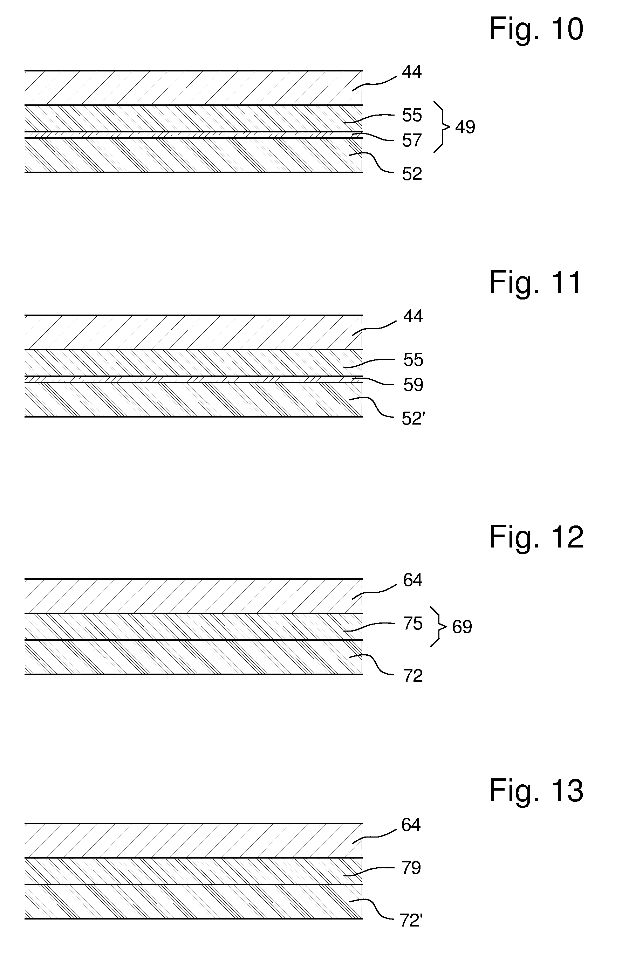

De plus, le couvercle et/ou la pièce principale peuvent être en métal et non en céramique. A titre d'exemple, les figures 10 à 13 présentent deux variantes avec un couvercle 44, 64 en métal. Typiquement, les métallisations 49, 69 enrobent totalement le couvercle et/ou la pièce principale lorsqu'ils sont en métal. On comprend toutefois que l'enrobage peut également être partiel sans effet négatif sur les moyens d'étanchéité 6.

Dans une première variante visible aux figures 10 et 11, le couvercle 44 en métal comme par exemple à base de kovar comporte une métallisation 49 à plusieurs couches. La métallisation 49 comporte au moins une couche de métal 55 comme du nickel ou du cuivre. La métallisation 49 peut également comporte un revêtement 57 de protection contre l'oxydation par exemple en or. La couche de métal 55 a une épaisseur de sensiblement 5 µm tandis que le revêtement 57 de protection est d'environ 0,1 µm.

Avantageusement selon l'invention, une couche 52 d'un matériau dont le point de fusion est inférieur à 250 °C est déposée sur le revêtement 57 par exemple formé en or. Comme expliqué ci-dessus, le matériau dont le point de fusion est inférieur à 250 °C peut être de l'indium ou de l'étain. Une représentation dans laquelle la couche 52 est déposée sur le couvercle 44 est visible à la figure 10.

L'épaisseur de la couche 52 est importante car, dans un premier temps, elle est utilisée pour former un premier intermétallique avec une des couches de protection et, dans un deuxième temps, elle est utilisée pour former un deuxième intermétallique avec au moins une des couches de la métallisation de la partie principale ou du couvercle comme expliqué ci-dessous.

Ainsi, après l'étape de diffusion destinée à diffuser partiellement le matériau dont le point de fusion est inférieur à 250 °C dans le revêtement 57 afin d'entièrement transformer le revêtement 57 en un intermétallique apte à former une couche 59 de protection de ladite au moins une couche 55 de métal. Une représentation dans laquelle la couche 59 est formée sur le couvercle 44 est visible à la figure 11.

On comprend donc qu'une partie de la couche 52 est utilisée et qu'à la fin de la phase 24 ou 26, la couche 52 devient la couche 52' moins épaisse mais toujours de même nature. A la fin de l'étape 24 ou 26, on comprend que ladite au moins une couche 55 comporte un revêtement 59 de protection contre l'oxydation par exemple en alliage or-indium ou or-étain et la couche 52' qui est le reste non diffusé de la couche 52 en indium ou en étain comme illustré à la figure 11. La couche 52 peut comporter une épaisseur comprise entre 15 et 60 µm et s'étendre sur toute ou partie du couvercle 44 et/ou tout ou partie de la métallisation 49.

Après diffusion, la couche 55 reste inchangée. Par contre, on obtient une couche 59 de protection de l'ordre de 5 µm et une couche 52' comprise entre 13,5 et 58,5 µm. Ces dépôts peuvent être réalisés, par exemple, par sérigraphie, galvanoplastie ou dépôt physique en phase vapeur.

Dans une deuxième variante visible aux figures 12 et 13, le couvercle 64 en métal comme par exemple à base de nickel ou de cuivre comporte une métallisation 69 à une seule couche. On comprend donc que le couvercle 64 forme une partie de la métallisation par rapport aux explications précédentes. La métallisation 69 comporte ainsi au moins une couche de métal 75 comme de l'or. La métallisation 69 forme donc toujours un revêtement de protection contre l'oxydation du couvercle 64. La couche de métal 75 a une épaisseur d'environ 0,1 µm.

Avantageusement selon l'invention, une couche 72 d'un matériau dont le point de fusion est inférieur à 250 °C est déposée sur la couche 75 par exemple formé en or. Comme expliqué ci-dessus, le matériau dont le point de fusion est inférieur à 250 °C peut être de l'indium ou de l'étain. Une représentation dans laquelle la couche 72 est déposée sur le couvercle 64 est visible à la figure 12.

L'épaisseur de la couche 72 est importante car, dans un premier temps, elle est utilisée pour former un premier intermétallique avec le couvercle 64 et, dans un deuxième temps, elle est utilisée pour former un deuxième intermétallique avec au moins une des couches de la métallisation de la partie principale comme expliqué ci-dessous.

Ainsi, après l'étape de diffusion destinée à diffuser partiellement le matériau dont le point de fusion est inférieur à 250°C dans la couche 75 afin d'entièrement transformer le revêtement 75 en un intermétallique apte à former une couche 79 de protection de ladite au moins une couche 55 de métal. Une représentation dans laquelle la couche 79 est formée sur le couvercle 64 est visible à la figure 13.

On comprend donc qu'une partie de la couche 72 est utilisée et qu'à la fin de la phase 24 ou 26, la couche 72 devient la couche 72' moins épaisse mais toujours de même nature. A la fin de l'étape 24 ou 26, on comprend que le couvercle 64 comporte une couche 79 de protection contre l'oxydation par exemple en alliage or-indium ou or-étain et la couche 72' qui est le reste non diffusé de la couche 72 en indium ou en étain comme illustré à la figure 13. La couche 72 peut comporter une épaisseur comprise entre 15 et 60 µm et s'étendre sur toute ou partie du couvercle 64 et/ou tout ou partie de la métallisation 69.

Après diffusion, le corps du couvercle 64 reste inchangé. Par contre, on obtient une couche 79 de protection de l'ordre de 5 µm et une couche 72' comprise entre 13,5 et 58,5 µm. Ces dépôts peuvent être réalisés, par exemple, par sérigraphie, galvanoplastie ou dépôt physique en phase vapeur.

Il peut également être envisagé de monter le circuit oscillateur dans la même cavité 10 que le résonateur 5 à quartz. Ce circuit oscillateur peut comprendre également une fonction d'horloge à temps réel (RTC) ou d'autres fonctions.

Il peut être envisagé également de monter un ou plusieurs MEMS 5 dans chaque boîtier 7 ou encore d'utiliser des matériaux alternatifs pour les boîtiers 7 comme du métal ou du verre, sans sortir du cadre de l'invention. De même, la forme des métallisations 9, 11 ne saurait se limiter à celle des figures 1 et 2.

Il est également possible que les phases 22, 24 et 26 ne soient pas totalement indépendantes en fonction de la technologie du MEMS employée. Il est ainsi envisageable que la phase 26 consistant à former la partie creuse 2 soit réalisée avant la phase 22 de formation du MEMS 5 dans le cas où ce dernier 5 est gravé directement dans cette première 2.

Enfin, un matériau du type « getter » peut être disposé dans le dispositif d'encapsulage 3 pour servir de pompe à vide, c'est-à-dire parfaire le vide dans le dispositif 3 déjà fabriqué, lorsqu'il est activé par exemple au moyen d'un laser ou durant le processus thermique de scellement/diffusion, simplement à l'aide de la température et du temps.

## Revendications

1. Elément (2, 4, 44, 64) agencé pour coopérer avec une autre pièce (4, 2) afin de former un dispositif d'encapsulage (3) d'un composant (5) comportant l'élément (2, 4, 44, 64) au moins partiellement revêtu d'une métallisation (11, 9, 49, 69) **caractérisé en ce que** ladite métallisation comporte au moins une couche (15, 16, 55, 64) de métal protégé par un intermétallique (19, 59, 79) lequel est recouvert par une partie (12', 52', 72') non diffusée d'un matériau dont le point de fusion est inférieur à 250 °C.

2. Elément (2, 4, 44, 64) selon la revendication précédente, **caractérisé en ce que** l'élément est un couvercle (4, 44, 64) destiné à fermer ledit dispositif d'encapsulage (3).

3. Elément (2, 4, 44, 64) selon la revendication 1, **caractérisé en ce que** l'élément est une partie principale (2) destinée à former une cavité (10) du dispositif d'encapsulage (3).

4. Elément (2, 4, 44, 64) selon l'une des revendications précédentes, **caractérisé en ce que** l'élément (2, 4, 44, 64) est formé en céramique ou en métal.

5. Elément (2, 4, 44, 64) selon l'une des revendications précédentes, **caractérisé en ce que** ladite au moins une couche (15, 16, 55, 75) de métal comporte du nickel et/ou du cuivre et/ou de l'or.

6. Elément (2, 4, 44, 64) selon l'une des revendications 1 à 4, **caractérisé en ce que** ladite au moins une couche de métal est formé par le corps de l'élément (64).

7. Elément (2, 4, 44, 64) selon l'une des revendications précédentes, **caractérisé en ce que** ladite au moins une couche de métal (15, 16) comporte en outre une couche (13, 14) d'accrochage contre ledit corps de l'élément (2, 4).

8. Elément (2, 4, 44, 64) selon la revendication précédente, **caractérisé en ce que** la couche (13, 14) d'accrochage comporte du molybdène et/ou du tungstène et/ou du titane et/ou du chrome.

9. Elément (2, 4, 44, 64) selon l'une des revendications précédentes, **caractérisé en ce que** l'intermétallique (19, 59, 79) comporte de l'or.

10. Elément (2, 4, 44, 64) selon l'une des revendications précédentes, **caractérisé en ce que** ledit matériau dont le point de fusion est inférieur à 250°C est de l'indium.

11. Elément (2, 4, 44, 64) selon l'une des revendications 1 à 9, **caractérisé en ce que** ledit matériau dont le point de fusion est inférieur à 250°C est de l'étain.

12. Procédé (24, 26) de fabrication d'un élément (2, 4, 44, 64) agencé pour coopérer avec une autre pièce (4, 2) afin de former un de dispositif d'encapsulage (3) d'un composant (5) comportant les étapes suivantes :
a) former l'élément (2, 4, 44, 64) ;
b) déposer une métallisation (9, 11, 49, 69) comportant au moins une couche (15, 16, 55) de métal protégé par un revêtement (17, 18, 57, 75) ;
**caractérisé en ce qu'**il comporte en outre les étapes suivantes :
c) déposer une couche (12, 52, 72) d'un matériau dont le point de fusion est inférieur à 250°C sur le revêtement (17, 18, 57, 75) ;
d) diffuser partiellement le matériau dont le point de fusion est inférieur à 250 °C dans le revêtement (17, 18, 57, 75) afin d'entièrement transformer le revêtement (17, 18, 57, 75) en un intermétallique et laisser une partie (12', 52', 72') non diffusée du matériau dont le point de fusion est inférieur à 250 °C.

13. Procédé (24, 26) selon la revendication précédente, **caractérisé en ce que** l'élément (2, 4, 44, 64) est formé en céramique ou en métal.

14. Procédé (24, 26) selon la revendication 12 ou 13, **caractérisé en ce que** ladite au moins une couche (15, 16, 55) de métal comporte du nickel et/ou du cuivre et/ou de l'or.

15. Procédé (24, 26) selon la revendication 12 ou 13, **caractérisé en ce que** ladite au moins une couche de métal est formé par le corps de l'élément (64).

16. Procédé (24, 26) selon l'une des revendications 12 à 15, **caractérisé en ce que** le procédé comporte, entre l'étape a) et l'étape b), une étape consistant à déposer une couche (13, 14, 33, 34) d'accrochage pour ladite au moins une couche (15, 16) de métal.

17. Procédé (24, 26) selon la revendication précédente, **caractérisé en ce que** la couche (13, 14) d'accrochage comporte du molybdène et/ou du tungstène et/ou du titane et/ou du chrome.

18. Procédé (24, 26) selon l'une des revendications 12 à 16, **caractérisé en ce que** le revêtement (17, 18, 57, 75) comporte de l'or.

19. Dispositif d'encapsulage (3) agencé pour recevoir un composant (5) comportant un boîtier (7) comprenant une partie principale (2) formant une cavité (10) qui est fermée hermétiquement par un couvercle (4, 44, 64) à l'aide de moyens d'étanchéité (6) **caractérisé en ce que** les moyens d'étanchéité (6) comportent un intermétallique (20, 40) formé par au moins un métal (15, 16, 15', 16', 55, 64) avec un matériau (12, 52, 72) dont le point de fusion est inférieur à 250 °C afin de permettre son interdiffusion à l'état liquide avec ledit au moins un métal.

20. Dispositif d'encapsulage (3) selon la revendication précédente, **caractérisé en ce que** les moyens d'étanchéité (6) comportent un deuxième intermétallique (19, 19', 39, 39', 59, 79) adjacent audit premier intermétallique (20, 40) formé par au moins un deuxième métal (17, 18, 57, 75) avec le matériau (12, 52, 72) dont le point de fusion est inférieur à 250 °C.

21. Dispositif d'encapsulage (3) selon la revendication précédente, **caractérisé en ce que** ledit au moins un deuxième métal (17, 18, 57, 75) comporte de l'or.

22. Dispositif d'encapsulage (3) selon la revendication 20 ou 21, **caractérisé en ce que** les moyens d'étanchéité (6) comportent un troisième intermétallique (40) de nature sensiblement identique au premier intermétallique, le premier et le troisième intermétallique étant situé de chaque côté du deuxième intermétallique (39').

23. Dispositif d'encapsulage (3) selon l'une des revendications 19 à 22, **caractérisé en ce que** les moyens d'étanchéité (6) comportent au moins une couche d'accrochage (13, 14, 33, 34) contre le boîtier (7).

24. Dispositif d'encapsulage (3) selon l'une des revendications 19 à 23, **caractérisé en ce que** les moyens d'étanchéité (6) comportent une couche dudit au moins un métal (15, 16, 15', 16', 55, 64) entre le couvercle (4, 44, 64) et ledit intermétallique (20, 40) et entre la partie principale (2) et ledit intermétallique (20, 40).

25. Dispositif d'encapsulage (3) selon l'une des revendications 19 à 23, **caractérisé en ce que** les moyens d'étanchéité (6) comportent une couche dudit au moins un métal (15, 16, 15', 16', 44) entre la partie principale (2) et ledit intermétallique (20, 40) et dans le couvercle (64).

26. Dispositif d'encapsulage (3) selon l'une des revendications 19 à 25, **caractérisé en ce que** ledit matériau dont le point de fusion est inférieur à 250°C est de l'indium.

27. Dispositif d'encapsulage (3) selon l'une des revendications 19 à 25, **caractérisé en ce que** ledit matériau dont le point de fusion est inférieur à 250°C est de l'étain.

28. Dispositif d'encapsulage (3) selon l'une des revendications 19 à 27, **caractérisé en ce que** ledit au moins un métal (15, 16, 15', 16', 55, 64) comporte du nickel et/ou du cuivre et/ou de l'or.

29. Dispositif d'encapsulage (3) selon l'une des revendications 19 à 28, **caractérisé en ce que** le boîtier (7) est formé en céramique et/ou en métal.

30. Dispositif d'encapsulage (3) selon l'une des revendications 19 à 29, **caractérisé en ce que** la cavité (10) est sous vide ou sous atmosphère contrôlée.

31. Procédé (21) de fabrication d'un dispositif d'encapsulage (3) d'un composant (5) **caractérisé en ce qu'**il comporte les étapes suivantes :
e) former ledit composant (5) ;
f) fabriquer une partie principale (2) comportant une première métallisation (11) et formant une cavité (10), et un couvercle (4, 44, 64) comportant une deuxième métallisation (9, 49, 69), la partie principale (2) ou le couvercle (4, 44, 64) étant réalisé conformément au procédé (24, 26) selon l'une des revendications 12 à 17 ;
g) monter (25) le composant (5) dans la cavité (10) ;
h) assembler (27) la partie (12', 52', 72') non diffusée du matériau dont le point de fusion est inférieur à 250 °C lors de l'étape d) de la partie principale (2) ou du couvercle (4, 44, 64) contre respectivement la métallisation (9, 11) du couvercle (4, 44, 64) ou de la partie principale (2) ;
i) diffuser (29) totalement la partie (12', 52', 72') non diffusée du matériau dont le point de fusion est inférieur à 250 °C dans ladite métallisation (11, 9, 49, 69) adjacente afin d'entièrement transformer le matériau dont le point de fusion est inférieur à 250 °C en un deuxième intermétallique (20) apte à fermer hermétiquement ledit composant dans le dispositif d'encapsulage (3).

32. Procédé (21) selon la revendication précédente, **caractérisé en ce qu'**il comporte, entre l'étape f) et l'étape g), l'étape consistant à déposer une couche (18, 17, 57, 75) de protection afin de protéger ladite métallisation formée non recouverte par la partie (12', 52', 72') non diffusée.

33. Procédé (21) selon la revendication 31 ou 32, **caractérisé en ce que** la partie principale (2) et le couvercle (4, 44, 64) sont formés en céramique et/ou en métal.

34. Procédé (21) selon l'une des revendications 31 à 33, **caractérisé en ce que** l'étape i) est réalisée sous vide ou sous atmosphère contrôlée.

35. Procédé (21, 24, 26) selon l'une des revendications 12 à 17 et 31 à 34, **caractérisé en ce que** ledit composant (5) est un résonateur diapason à quartz.

36. Procédé (21, 24, 26) selon l'une des revendications 12 à 17 et 31 à 35, **caractérisé en ce que** le matériau dont le point de fusion est inférieur à 250°C est de l'indium.

37. Procédé (21, 24, 26) selon l'une des revendications 12 à 17 et 31 à 35, **caractérisé en ce que** le matériau dont le point de fusion est inférieur à 250°C est de l'étain.
